# EUROPEAN PATENT APPLICATION

(11) **EP 2 916 633 A1**
(43) Date of publication of application: **09.09.2015**
(21) Application number: 14157503.5
(22) Date of filing: 03.03.2014
(51) Int. Cl.: H05K 7/14, H05K 7/20

(54) **Modular data center**

(71) Applicant: Knürr GmbH, 94424 Arnstorf (DE)
(72) Inventor: Willnecker, Manfred, 94439 Rossbach (DE)
(74) Representative: Heim, Florian Andreas

(57) **Abstract**

The invention relates to a modular data center having at least two different types of modules, an IT module and an end module. In the IT module a row of cabinets is provided so that one side of the row is positioned at a first lateral side of the IT module and this lateral side is closed at least partially by sealing means, which extend from the ceiling to the top of each cabinet in the row of cabinets, in a manner that airflow from the interior of the IT module to the outside of the IT module through this lateral side passes through the cabinets of the row. The end module and the IT module are coupled side by side so that a lateral side of the end module faces the lateral side of the IT module and in a way that an airflow from the interior of the IT module to the interior of the end module through the cabinets of the row is enabled. Based on this construction during operation, the interior of one module forms a hot aisle and the interior of the other module forms a cold aisle. Further on, cooling means are provided for cooling heated air of the hot aisle and for transferring the cooled air into the cold aisle.

## Description

The invention relates to a modular data center comprising a plurality of cabinets. These cabinets are used, for example, to house IT and/or telecommunications equipment like servers, network switches or the like.

This kind of IT equipment is often placed in 19-inch frames which are situated in cabinets. The cabinets are also referred to as enclosures or racks. It is also possible that the IT and/or the telecommunications equipment form an integrated unit with the cabinet.

Besides of the power and network cabling of a data center, one major task is the thermal management of these centers. Generally, air is used for cooling heat producing IT components like the CPU of servers. Commonly, air is transferred by means of fans to the heat producing components so that they can transfer their heat to the air. The heated air is then cooled by e.g. computer room air conditioners (CRAC) or computer room air handlers (CRAH) wherein heat load is transferred from air to a second medium, e.g. water or coolant, by means of a heat exchanger or a coil. Following, the cooled air is transferred again to the heat producing elements of the IT structure and used to cool them.

To improve the thermal management, it is known to arrange the cabinets of a data center in rows forming hot and cold aisles. Often these aisles are enclosed. If the cooling units, which are used for cooling the heated air, are not placed in the rows of cabinets, it is known to use a raised floor or at least parts of the raised floor to transfer cool air to places in the data center where this cool air is needed. Hot or cold air can also be ducted in a drooped or suspended ceiling, in addition to a raised floor or as an alternative to a raised floor. The space between the dropped ceiling and the main or structural ceiling of the room is then also used for transferring either cool or hot air. If solutions with a suspended ceiling and/or raised floor are used, the room is normally required to have a total height of more than 3 1/2 meters.

Solutions for a thermal management are for example known from DE 20 2013 10 519 U1 or WO 2010/000440.

One way to speed-up the construction process of a data center is to use a modular designed data center. The different modules of this type of data center can be equipped in advance and then be transported to the site where the data center should be built. The building of a data center in this manner can be compared to the building of a prefabricated house. In this context it is known to use containers for the outer casing of a module.

In case that standard containers are to be used, there is the problem that these containers are normally not wide enough to place cabinets in an efficient way inside the container so that access to the interior of the cabinets from the front as well as from the back is enabled. This is especially the case considering that a standard ISO-container has a width of about 2.3 meters and a cabinet such as for example a KNÜRR-DCM-cabinet used as a server or networking rack has a depth of in most cases 1.0 to 1.2 meters, sometimes up to 1.6 meters and a width of up to 0.8 meters.

In view of this space issue, it is for example known to place the cabinets inside a standard container on rail or tracks so that they are movable to access the cabinet's interior either from the front or the back. This construction is of course complex and cost-intensive. Also, the space left in the container which can be used for the airflow intended for cooling the components inside cabinets is fairly reduced so that also the thermal management is quite complicated.

Another possibility to construct a data center based on containers is e.g. shown in WO 2011/127125 A2.

It is an **object** of the invention to create a modular data center which is optimized in view of the thermal management.

This object is achieved according to the invention through a modular data center having the features of claim 1.

Further, preferred embodiments of the invention are discussed in the dependent claims, the specification as well as the description of the figures and the figures themselves.

A modular data center according to the invention has at least two different types of modules, an IT module and an end module. Each module can have a cuboid form comprising a top and a bottom side, a front and a back side, a first and a second lateral side having the same length as the top and the bottom side, respectively. The top side forms an interior ceiling. In the IT module a row of cabinets is provided. One side of the row, i.e. either cabinet fronts or cabinet backs, is positioned at or close to the first lateral side of the IT module sealing means extend from the ceiling to the top of each cabinet in the row of cabinets. This first lateral side is closed by means of the row, the sealing means and eventually further means in a manner that air flowing from the interior of the IT module to the outside of the IT module through the first lateral side, or vice versa, has to pass through the cabinets of the row. As today cabinets, e.g. for servers, usually comprise a hot-cold-separation, i.e. most or all openings at front 19"-plane are sealed, air has to pass through devices inside the cabinet. Additionally, the end module and the IT module are coupled side by side in a way such that the second lateral side of the end module faces the first lateral side of the IT module so that an airflow from the interior of the IT module to the interior of the end module or vice versa through the cabinets in the row is enabled. During operation of the data center the interior of one of these two modules forms a hot aisle and the interior of the other module forms a cold aisle. Additionally, cooling means are provided for cooling heated air of the hot aisle and for transferring the cooled air to the cold aisle.

A core idea of the invention can be seen in the way the row of cabinets is placed inside the IT module. In detail, the row is positioned at a first lateral side of the IT module. In other words, all fronts or backs of the cabinets in this row are positioned in direction of the first lateral side. Accordingly, if, for example, the cabinets are placed so that the fronts face the first lateral side, even in a standard container, it is possible to open the back doors and access the interior of the cabinets from the back.

Further on, as the end module with its second lateral side is placed next to the first lateral side of the IT module, an access to the interior of the cabinets from the front is also possible as the interior of the cabinets can be reached by opening the front doors which reach into the end module.

In view of the inventive modules it is not always required that both lateral sides, the front and/or the back side, are closed with panels. In detail, the lateral sides as well as the front and/or back sides can also not be closed to allow access to the interior of the module or to objects such as cabinets placed inside the module. If the walls or sides between adjacent modules are not closed, an airflow between these two modules can also be enabled.

A further aspect of the invention is the fact that the first lateral side of the IT module is closed or sealed in such a manner that the airflow from the interior of the IT module to the outside of this IT module through the first lateral side, or vice versa, is only possible by passing through the cabinets. This can for example be achieved in providing sealing means, like panels, extending from a top region of each cabinet to the ceiling of the module. If the row of the cabinets does not extend along the entire lateral side of a module, it is also possible to seal the rest of the side, for example by panels or by providing a door or the like.

Based on this inventive construction, there are two substantially sealed areas within the IT module and the end module. In the following, one of these areas is referred to as hot aisle and the other one as cold aisle. An additional inventive aspect is that the boundaries of the aisle can be at least partly formed or defined by the sides to the modules. These areas have the same effect as the construction of hot and cold aisles in standard data centers. In other words, during operation, the devices inside the cabinets draw cool air by means of fans from the cold aisle and eject or admit the heated air into the hot aisle. Additionally, the air pressure inside the cold aisle can be slightly higher than the pressure in the hot aisle.

The cabinets may be placed directly or by means of a plinth on the bottom or floor of the IT module. It is also possible to place them on a raised floor.

According to an advantageous embodiment, two or more IT modules are provided. These modules are coupled preferably side by side so that the first lateral side of one IT module faces the second lateral side of the next IT module. Further on, an airflow from the interior of one IT module to the interior of the next IT module which is placed next to the one IT module, or vice versa, through the cabinets in the rows is enabled. In a preferred embodiment, airflow is only possible through the cabinets. Thereby hot aisles and cold aisles are formed in an alternating manner.

By this kind of construction, more rows of cabinets can be provided and the central idea of the invention can be extended to a data center having more than one IT module. The construction of the IT modules is always quite the same. The further IT modules are placed next to the first IT module in the same way the first IT module is placed side by side or next to the end module. Benefits or advantages of this construction are that, irrespective of the size of the data center which is to be built, the same or nearly the same kind of IT modules can be used. This is an advantage in view of the manufacturing of the IT modules as the same or nearly the same modules can be used, as mentioned above, for differently sized data centers.

Besides the varying cabinets and interiors of the cabinets which can be used, a main difference between the different IT modules used is the direction in which the cabinets are placed inside each IT module. To provide hot and cold aisles inside adjacent IT modules, the cabinets are placed either with their fronts or with their backs facing the first lateral side. This results in that, in the IT modules forming hot aisles, the cabinets are placed so that their fronts face the first lateral side. In contrast, the cabinets positioned in IT modules forming cold aisles are positioned in a way that their backs face the first lateral side of the IT module.

In an advantageous embodiment, the cold aisles and/or hot aisles are interconnected fluid technically, respectively, via connections being on the same ground level as the cold aisles and/or hot aisles. Thereby, cold and/or hot areas are formed. Accordingly, there is no need for raised floors and/or suspended ceilings.

The terms "thermal fluid technical connection" and "fluid technically connected" in the sense of the invention can be understood to permit an airflow between two elements which are fluid technically connected. The same also refers to the terms "connection" and "connected" themselves as they can also have the meaning of a fluid technical connection and being fluid technically connected.

A cooling system with a first degree of redundancy can be achieved, if a cold or hot area is formed. For example in the case that only a cold area is formed, if one cooling means has a malfunction and is not cooling anymore or not sufficiently, the ramifications of this malfunction are alleviated due to the fact that there is also an air circulation inside the connected cold aisles, forming the cold area, so that even if one cooling means fails to provide enough cool air, the cool air generated by the remaining cooling means can be used for the other cold aisles. In detail, the data center is operated with all present cooling means at low fan speed. If one cooling means has a malfunction, the fan speed of the fans of the remaining cooling means is increased to provide enough cool air.

If a cold and a hot area is formed by connecting all cold and all hot aisles, respectively, a cooling system for a data center with a second degree of redundancy can be achieved. In detail, this second degree of redundancy is preferred as here both thermal sides - all cold aisles and all hot aisles - are designed redundantly. If only one side is designed redundantly - e.g. if all cold aisles are interconnected - and a malfunction of a cooling means occurs, hot air of the hot aisle the cooling means is adjacent to has to pass in a non-cooled state into a cold aisle to remove the hot air of this hot aisle. As a result the cooling capacity of the remaining cooling means has to be increased, e.g. by lowering the temperature of the cooling fluid. This decreases the energy efficiency of the data center. If, in contrast thereto, the data center is provided with a second degree of redundancy - i.e. all cold aisles and all hot aisles are interconnected, respectively -, it will be possible to stop the airflow through the defect cooling means and to increase only the fan speed of the remaining cooling means.

There are several possibilities to interconnect the cold and/or hot aisle. In one embodiment the cold and/or hot areas have a comb-like layout, wherein a shaft of the comb-like layout is formed by the connection, respectively, and teeth of the comb-like layout are formed by the cold and/or hot aisles, respectively. If a cold and a hot area based on this comb-like layout is formed, it is preferred that the cold and hot aisles intertwine. It is also possible to name this kind of layout finger-like, wherein the cold and hot aisle form fingers which intertwine.

This leads to a layout of a datacenter wherein cold aisles and hot aisles are formed in one spatial direction in the alternating manner and wherein the one or more connections extend in this spatial direction. Hereby, cold aisles and/or hot aisles, respectively, can be placed parallel to each other, and are interconnected by the connections. These connections may extend in a direction substantially perpendicular to the longitudinal direction of the aisle. Dependent on the available building area, the connection can define also an angle with the aisles which is slightly or even significantly different to a 90° angle.

The connection between the aisles can be created in different ways and by many different means. One possibility is to use walk-in corridors for the connections. In this kind of usage, the walk-in corridors can fulfill a double function. They can on the one hand provide a fluid technical connection between cold and/or cold aisles, respectively, and on the other hand provide physical access to the interior of the cold and/or hot aisles.

In a further embodiment, the connection is formed by a corridor module forming a cold or hot corridor, respectively, being directly or indirectly fluid technically connected to hot or cold aisles of the IT modules and the end module, respectively. In an alternative embodiment, the corridors forming the connections may be integrated in the IT module and end module.

It is possible that the row of cabinets comprises at least one cooling means for cooling heated air of a hot aisle and transferring the cooled air to a cold aisle. By using an in-row cooling means which are often smaller than a cabinet and have a width of 300 mm or 600 mm or may have the same form factor as the cabinet, it is easily possible to transfer the air of the hot aisle to the cold aisle and during this transfer also to cool the air. As based on the modular construction of a data center, each row of a cabinet is always next to a cold or/and a hot aisle, preferably in the way that the fronts of the cabinets face the cold aisle, it is easily possible to provide the in-row cooling means in the row of cabinets. The advantage of this solution is that, as a minimum requirement for building an inventive data center, only one end module and a number of IT modules are needed depending on the size of the data center and in-row cooling means in the rows of cabinets. An alternative to in-row cooling means is a cooling unit with can be placed on top and/or below the cabinets. It is also possible to use cooling units, which are integrated into the cabinets. Of course a combination of or several different of these other cooling means may also be used.

Instead of or in addition to the placement of the cooling means inside or near the cabinets, the cooling means can be placed inside the corridor module along one of the lateral sides of the corridor module. So a combined cooling corridor module is formed. These kind of combined cooling corridor module have a third functionality in addition to the two functionalities - fluid technical connection and physical access. In detail, space for cooling means is provided. In the combined cooling corridor module, the cooling modules are preferable placed transverse to the lateral axis of the cooling module facing cold or hot aisles. In providing the cooling means inside a cooling module, there is the advantage that more space in the rows of cabinets in the IT module can be used for computing devices or network devices. A further advantage of the construction and usage of cooling modules of any type is, as the cooling means are commonly implemented as a fluid-air-heat exchanger and therefore need for example cool water, there is no need to provide water inside the IT module(s). Additionally the cooling means can be concentrated in the cooling modules. Thus, all or most thermal technology is situated only in one or a few modules.

There exist further possibilities than cooling means in IT-modules or combined cooling corridor modules for cooling the data center. It is, for example, possible to provide at least one specialized cooling module of a first type. This cooling module can have a similar or nearly similar form factor as the end module or IT modules. It is favorable for the cooling module to have a length which is a multiple of the width of the IT and end modules. The cooling module can be coupled to the IT module(s) and the end module in a way that one lateral side of the cooling module faces the front sides or back sides of the IT module(s) and the end module. Inside the cooling module of the first type, there are separations extending the hot and cold aisle(s) to form hot and cold compartments. This extension of the hot and cold aisle(s) is realized if the cooling module is coupled in the above described way. Further on, inside the cooling modules cooling means are provided for cooling heated air of the hot aisle(s) and for transferring the cooled air to the cold aisle(s) via cold compartments. The cooling means can be a part of the separation.

It is preferred that the cooling means in the first type of a cooling module are placed transverse to the lateral axis of the cooling module. The same applies for the separations. As explained above, based on this cooling module type the hot and cold aisle(s) are prolonged by the hot and cold compartments of the cooling module. In providing the cooling means inside a specialized cooling module there is again the advantage that more space in the rows of cabinets in the IT module can be used for computing devices or network devices.

In a further embodiment a corridor module is coupled side by side to a first cooling module of the first type so that the lateral side of the first cooling module, which is opposite to the lateral side of the first cooling module facing the IT module(s), and the end module faces a lateral side of the corridor module. Additionally, the corridor module can be fluid technically connected to the hot or cold aisle(s) of the IT module(s) and the end module via hot or cold compartments, respectively. Thereby, a hot or cold corridor inside the corridor module, respectively, is formed. As explained, the hot and cold compartments of the first cooling module of the first type prolong or extend the hot and cold aisles. By placing the corridor module next to the cooling module and connecting the interior of the corridor module either to the hot or to the cold compartments either a hot or a cold corridor is formed. The result of the formation of the hot or cold corridor is that either all hot or all cold aisle(s) are inter-connected.. This leads to the advantage that for the cooling system a first degree of redundancy can be achieved.

If, for example, a cold corridor is formed and all cooling means transfer their cooled air into the cold compartment which they are situated next to, all cold aisles are connected due to the fact that all cold compartments are on the one hand connected to the cold corridor and on the other hand are each connected to one cold aisle. So a cold or hot area is realized by the cold aisles and the cold corridor or the hot aisles and the hot corridor, respectively

In a further advanced construction of the above explained arrangement, a second cooling module likewise of the first type is provided. This second cooling module is coupled to the IT module(s) and the end module in a way that one lateral side of the second cooling module faces the sides of the front sides or the back sides of the IT module(s) and the end module which are opposite to the sides facing the first cooling module of the first type. In other words, the first cooling module is placed for example adjacent to the front sides of the IT module(s) and the end module and the second cooling module is placed adjacent to the back sides. The second cooling module of the first type is constructed similarly to the first cooling module of this type and therefore has also separations extending the hot and cold aisle(s) which form hot and cold compartments. This cooling module also comprises cooling means for cooling heated air of the hot aisle(s) and for transferring the cooled air to the cold aisle(s) via cold compartments. The cooling means form a part of the separation.

According to this embodiment, there is provided a second corridor module which also forms a hot or cold corridor, respectively. This corridor module is coupled side by side to the second cooling module of the first type so that the lateral side of the second cooling module, which is opposite to the lateral side of the second cooling module facing the IT module(s) and the end module, faces the lateral side of the corridor module. Additionally, the corridor module is fluid technically connected via the second cooling module of the first type to the aisle(s) to which the cooling module of the first type is not fluid technically connected.

It is also possible to construct a data center by omitting the second cooling module of the first type and using only one cooling module and two corridor modules. Here, the second corridor module is arranged with one of its lateral sides facing the sides of the IT modules and the end module, which are not facing the lateral side of the first cooling module. Generally, the advantage of two cooling modules is that the cooling capacity can be improved.

So, in summary, at the front sides as well as at the back sides of the IT module(s) and the end module, a combination of a cooling module of the first type and a corridor module placed next to the cooling module or only a corridor module is provided. The corridor module near the front sides is e.g. connected to the hot compartments and, based on the explained construction, the other corridor module is connected to the cold compartments or the cold aisles directly. Due to this construction, a connection of all cold aisle(s) through the corridor module forming the cold corridor and all hot aisle(s) by the corridor module forming the hot corridor is provided. This leads to a second degree of redundancy of the cooling system, which is similar to the above-explained redundancy aspect, achieving that a malfunction of one or several cooling means does not cause a thermal problem in the data center.

It is also possible to use only one or more corridor modules, being arranged directly at the IT module(s) and the end module, without any cooling modules. In this case, it is preferred to provide in-row cooling means.

In an alternative embodiment, it is possible to provide a specialized redundancy module.

This redundancy module is coupled to the IT module(s) and the end module in a way that the lateral side of the redundancy module faces the front sides or the back sides of the IT module(s) and the end module. The redundancy module itself has a horizontal separation forming a hot air duct and a cold air duct. Further on, openings and air guides are provided for fluid technically connecting the hot aisle(s) to the hot air duct and the cold aisle(s) to the cold air duct. Preferably, the hot air duct is an upper air duct and the cold air duct is a lower air duct or vice versa.

With this construction of a redundancy module, it is possible to connect all hot aisles and all cold aisles of the IT modules, respectively. Accordingly, the usage of the redundancy module leads to the same advantage relating to redundancy in view of a malfunction of one cooling means, as already explained above. Hence, the redundancy module can replace two corridor modules taking into account that the cross section which is provided for air exchange between hot aisle or cold aisles, respectively, is reduced so that less air and thus less cooling energy can be transferred.

In connection with the redundancy module it is advantageous to use a cooling module of a second type, which can be coupled side by side to the redundancy module in a way that the lateral side of the redundancy module, which is opposite to the lateral side of the redundancy module facing the IT modules and the end module faces a lateral side of the cooling module. This cooling module is also provided with cooling means for cooling heated air of the hot air duct and for transferring the cooled air to the cold air duct.

The cooling module of the second type is preferably used together with the redundancy module. Hence, the redundancy module and this cooling module also have to be adapted to each other so that, if the hot duct is the upper duct, the cooling means of this cooling module may also draw the hot air from the upper duct and blow the cooled air to the lower duct which is used as a cold duct. In case of the usage of these two ducts the other way round, the cooling means of the cooling module have of course to be adapted to this different use. Cooling means of this type are referred to as upflow and downflow cooling means, respectively.

In a further alternative embodiment, each IT module has two ducts which are arranged on each other. Both ducts extend from the first lateral side to the second lateral side of each IT module so that hot aisles and cold aisles of plural IT modules and the end module are fluid technically connected, respectively. Based on this construction, it is possible to omit or waive a special realized redundancy module. This is due to the fact that the two ducts which are provided within each IT module already provide a redundancy if plural IT modules are connected to each other as the hot aisles are connected via the hot duct of the IT modules and all cold aisles are also fluid technically connected via the cold duct of the IT modules.

In a further alternative embodiment, a first cooling module of a third type is provided which may be compared to or may be similar to the combined cooling corridor module. This cooling module is coupled to the IT modules and the end module in a way that one lateral side of the cooling module faces the front sides or the back sides of the IT modules and the end module. The cooling module is fluid technically connected to the cold aisles or the hot aisles of the IT modules and the end module thereby fluid technically connects the cold aisles or the hot aisles with each other forming an extended cold aisle or an extended hot aisle. Additionally, within the cooling module of this third type, cooling means for cooling heated air of the hot aisles or extended hot aisle and for transferring the cooled air to the cold aisles or extended cold aisle are provided.

In this construction, the cooling means inside the cooling module are situated in a way that they are closing the hot aisles as the cooling means are situated at the end of the hot aisles. For example, if the cooling means are positioned in a way that they are closing the hot aisle, the cold aisles are extended to the rest of the cooling modules thereby forming an extended cold aisle. In this case, the cooling modules will draw the heated air from the hot aisles and will blow the cooled air to the extended cold aisle they are situated in. The advantage of this construction is that a redundancy for either the cold aisles or the hot aisles is provided.

In a further development of this construction, a second cooling module again of the third type is provided. This cooling module is coupled to the IT modules and the end module in a way that one lateral side of the cooling module faces the sides of the front sides or back sides of the IT modules and the end module which are opposite to the sides facing the first cooling module of the third type. This cooling module is also fluid technically connected to the aisles of the cold aisles or hot aisles of the IT modules and the end module which are not fluid technically connected to the first cooling module of the third type. Thereby, a fluid technical connection of the aisles of the cold aisles or the hot aisles with each other is formed, which are not fluid technically connected to the first cooling module of the third type, and an extended cold aisle or extended hot aisle is formed. In this second cooling module of the third type also cooling means for cooling heat air of the hot aisles or extended hot aisle and for transferring the cooled air to the cooled aisles or extended cooled aisle are provided.

In other words, one cooling module of the third type is provided on one side of the IT modules and the end module and another one on the other sides. One of these cooling modules, for example the one facing the front sides of the IT modules and the end module, is forming an extended cold aisle connecting all cold aisles whereby the cooling means are placed at the end of the hot aisles. In contrast thereto, the cooling module which is situated on the back sides of the IT modules and the end module is forming an extended hot aisle, whereby the cooling means are placed in a way that they close or seal the cold aisles.

This construction allows that all hot aisles and all cold aisles are connected via the cooling modules, respectively. This also provides a redundancy for a thermal management.

In a further embodiment, panels and/or doors or other sealing means are provided in each module to at least partly sealing the module in an air tight or substantially air tight manner. The panels or doors can be placed on the or at the regions or areas, especially front, back or lateral sides if an airflow through these regions or areas is not desired.

By means of the doors, it is possible to provide access points to the modules.

The cables needed for the operation of the devices in the cabinets of the rows can be provided above these cabinets. These cables may for example be for network and/or power issues. If in-row coolers of a type of fluid-air-heat exchangers are used pipes for warm and cold fluid can also be placed above the rows of cabinets. If the cabinets are not directly placed on the bottom of the IT module but by means of a plinth, these fluid pipes can especially be provided below the IT modules. This arrangement is preferred considering possible leaking of the pipes.

Preferably, the exterior of each module is at least partly formed by a standard ISO-container wherein the lateral, front and back panels may be at least partly removed and may be temporarily closed for transport from factory to construction site. A standard 20 feet or 40 feet container can for example be used. If extra height is needed, it is also possible to use a so called high cube container. Hence, a modular containerized data center can be provided.

If openings or cutouts are provided in the lateral, front and/or back walls of the container, these openings or cutouts can be temporally closed, e.g. by OSB panels, for transport to the construction site. In this case, the rows of the cabinets inside the modules are placed such that they enable the temporal closure, e.g. at a distance of several cm to the lateral side. Therefore, the term "placed at the first lateral side" can according to the invention also be understood as "placed at a small distance to the first lateral side".

In the above explanation, it was referred to a second type and a third type of a cooling module. Depending on the respective usage, these two types can also be the same type of module.

Additionally, the modular data center as described herein is not limited to modules being formed by standard containers, but it is also possible to use the teaching of this invention for constructing a data center inside existing buildings which have a low ceiling height as a result of which the standard solutions for data centers using raised floors and/or false ceilings cannot be used. These modules may have a ceiling height of less than 3 meters.

As explained above, a central idea of the invention is to interconnect cold aisles and/or hot aisles, respectively, being placed parallel to each other, via connections. These connections extend in a direction substantially perpendicular to the longitudinal direction of the aisle. The connections can be realized by corridors, parts of corridors, corridors comprising cooling means, corridor modules, cooling modules, redundancy modules and/or in-module ducts.

The invention will be explained in greater detail below using exemplary embodiments and schematic drawings, in which
- fig. 1: shows a layout of a modular data center according to the invention;
- fig. 2: shows a sectional view of the modular data center of fig. 1;
- fig. 3: shows a sectional view of an alternative embodiment of an IT module;
- fig. 4: shows a sectional view of a part of a modular data according to the invention;
- fig. 5: shows a layout of a further embodiment of a modular data center according to the invention;
- fig. 6: shows a layout of a further embodiment of a modular data center according to the invention;
- fig. 7: shows a layout of a further embodiment of a modular data center according to the invention;
- figs. 8a to 8c: show sectional views of a redundancy module;
- fig. 9a: shows a layout of an alternative embodiment of an IT module;
- fig. 9b: shows a sectional view of the IT module of fig. 9a;
- fig. 10: shows a layout of a further embodiment of a modular data center according to the invention;
- fig. 11: shows a layout of a further embodiment of a modular data center according to the invention;
- fig. 12: shows a layout of a further embodiment of a modular data center according to the invention;
- fig. 13: shows a layout of a further embodiment of a modular data center according to the invention; and
- fig. 14: shows a layout of a further embodiment of a modular data center according to the invention.

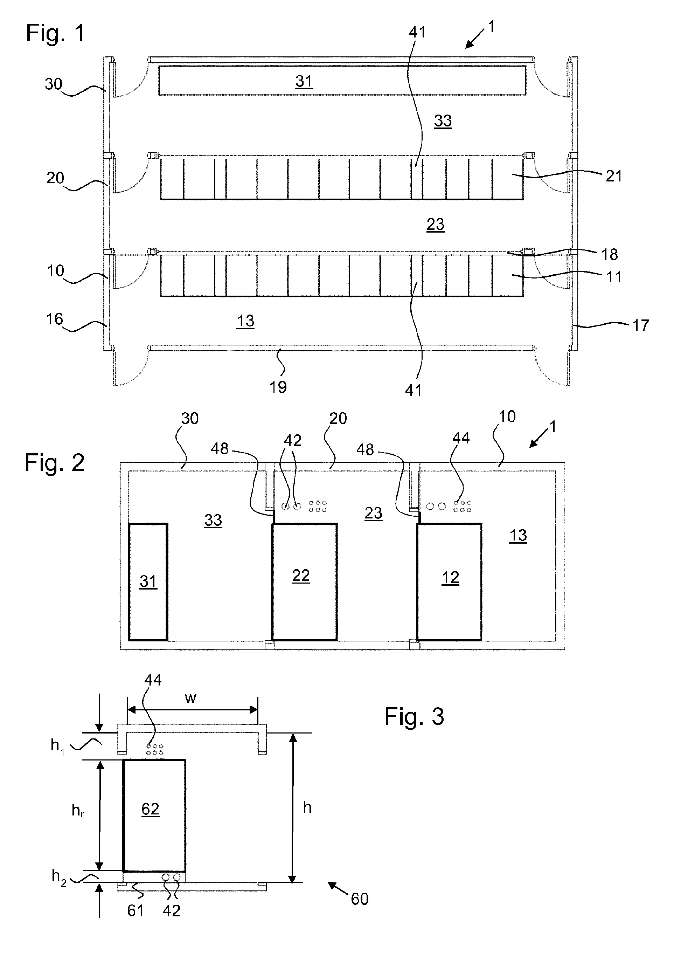

Fig. 1 shows a layout of a data center 1 according to the invention. This data center is built up by a first IT module 10, a second IT module 20 and an end module 30. Each module comprises a front side 16 and a back side 17 as well as a first lateral side 18 and a second lateral side 19. A layout of a data center in this specification is always a horizontal cut at the height of the cabinets.

In each IT module 10, 20 a row of cabinets 11 and 21 is provided. These rows are situated at the first lateral side 18 of each IT module 10, 20. At the first lateral side 18 of the end module 30 technical work space 31 is provided e.g. for technicians or for, inter alia, accommodating UPS systems (uninterrupted power supply), low-voltage distribution systems, fire extinguishing systems.

In the following, the thermal management and the more detailed construction of the inventive modular data center 1 will be explained with reference to fig. 2. Fig. 2 shows as sectional view of the modular data center 1 of fig. 1. As explained, the rows 11, 21 of cabinets, wherein in fig. 2 in each case only one cabinet 12, 22 is shown, are positioned inside their IT module 10, 20 at or near the first lateral side 18. If a container is used to construct an IT module, the container must not necessarily have lateral side walls or can be provided with cutouts being slightly higher than the cabinets and slightly longer than the row of cabinets. Further on, the free space above the cabinets 12, 22 is closed, for example by a panel 48 to stop or at least reduce an airflow from the interior of each IT module 10, 20 and the end module 30 to another IT module 10, 20 or the end module 30. Due to this construction an airflow, for example from the end module 30 to the interior of the second IT module 20 is only possible through the cabinets 22 and vice versa. The same applies to an airflow from the second IT module 20 to the first IT module 10 which is only possible by passing the cabinets 12 of the row 11 of cabinets of the first IT module 10.

Generally in data centers cabinets within the same row are placed in the same orientation. This means that all fronts of one cabinet in a row are orientated in the same direction. Normally, devices are installed inside a cabinet in a manner that they draw air from the front side of the cabinet and emit heated air at the back sides of the cabinets.

In the embodiment shown in fig. 2, the cabinets in row 12 in the first IT module 10 are placed in a way that the front sides of the cabinets are directed to the interior of the first IT module. In the opposite thereto, the cabinets in row 22 of the second IT module 20 are positioned in a way that the front sides are oriented in the direction of the end module 30.

This arrangement of the cabinets in rows 11 and 21 leads to the effect that the hot air is blown into the interior of the second IT module 20, wherein the cabinets of the first IT module 10 suck in cold air from the interior of the IT module 10. The cabinets of row 21 of the second IT module 20 suck in their cold air from the interior of the end module 30.

In summary, it can be said that due to this construction a cold aisle 13 is formed in the interior space of the IT module 10, a hot aisle 23 in the interior space of the second IT module 20 and a cold aisle 33 in the interior of the end module 30. To provide cool air to the cold aisles 13 and 33 by cooling the air of the hot aisle 23 cooling means are required. Preferably, these cooling means are air-fluid-heat exchangers which cool air with the aid of a fluid they are provided with. Thereafter, the fluid itself is normally cooled by external chillers which are for example installed on the roof of a data center.

In opposite to the common method to define hot and cold aisle by the usage of a roof-like structure to construct hot and cold aisle containments, the hot and cold aisle of the inventions are defined by the modules so that no additional roof-like structure or the like is needed.

In the embodiment shown in figs. 1 and 2, in-row coolers 41 having a form factor quite similar to the other cabinets in the row are preferably used. These in-row coolers 41 suck air from hot aisle 23, cool it and blow it to the cold aisle 13 and 33. In-row coolers are preferred in smaller data centers having less thermal needs or as additional cooling means for data centers having cooling modules, which will be explained below, to improve the overall cooling power.

Further on, in the sectional view of fig. 2 fluid pipes 42 are shown above the cabinets. These fluid pipes provide cold fluid to the in-row coolers 41 and guide the heated fluid to the above-mentioned external chillers. Next to the fluid pipes 42 there is a further space for the cabling, e.g. power cables 44, of the cabinet and the devices inside. Particularly, network and/or power cables are provided.

Fig. 3 shows a slightly different embodiment of an IT module 60. In this IT module 60 the cabinet 62 is not placed directly on the floor as shown in the embodiment of fig. 2 but is placed on a small plinth 61. Inside this plinth 61 it is possible to provide space for the fluid pipes 42. This provides the advantage that in case of leakage, fluid will not drop into the cabinets and to the devices like servers provided in these cabinets.

Additionally fig. 3 shows an example for the dimension of a module. If a standard ISO-container is used for the exterior of the modules the modules have an interior width w of about 2350 mm and an interior height h of about 2700 mm. Considering a height of about 2000 mm hᵣ for the cabinet or an IT rack, there remain 700 mm in height. In the embodiment shown in fig. 3, about 200 mm of height h₂ are required for the plinth 61 so that there remains a height h₁ of about 500 mm. If thermal isolation of a container is further provided, the interior height is reduced by about 200 mm to 300 mm. Thermal isolation is only required in containers or modules having an exterior wall, floor or ceiling after the set up of the data center has been completed. In the example shown here, an ISO high cube container is used. The interior height of a standard container is even less, namely about 2400 mm. These figures illustrate that when providing and using containers, even high cube containers, it is impossible to use the standard solutions with false ceilings and/or raised floors.

If container-like structures for the exterior of the modules are used, the equipping, for example the installation of the cabinets, can be carried out at the production facility, at the construction side or on both places. Further on, if containers are used for the exterior of the modules, it is possible to provide openings which can have different sizes in the front, back and both lateral sides. These openings can be used for air exchange. Furthermore, the cabinets could for example be placed inside these openings to seal the lateral sides. It is possible to place for example doors inside these openings. On the other hand, it is also possible to completely remove one side of a container and then use panels to close these parts of the containers which should not be open.

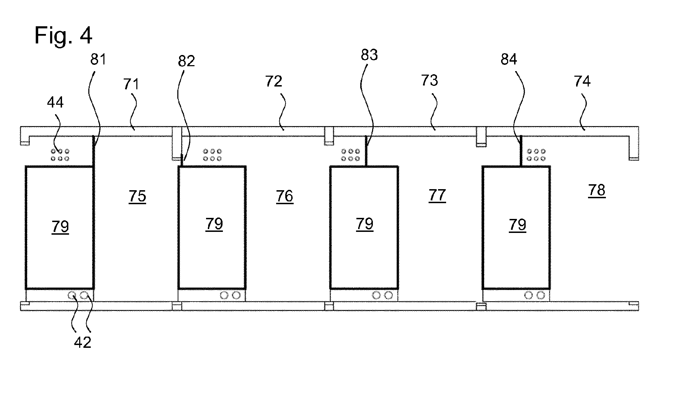

Fig.4 shows a sectional view of a part of a modular data center according to the invention. There are shown four IT modules 71, 72, 73, 74. In each IT module 71, 72, 73, 74, a row 79 of cabinets is deployed in the above explained manner. Accordingly, cold aisles 76, 78 and hot aisles 75, 77 are formed.

It is preferred that the cabling or wiring 44 of e.g. the network and power cables is situated in a cold area of the data center. Therefore, the sealing means or panels 81, 82, 83, 84 extending from the ceiling to the top of the cabinets in each row 79 are positioned in a manner that the cabling 44 is situated in a cold aisle 76, 78.

It is also possible to provide the sealing means 81, 82, 83, 84 in the region of the back side of each cabinet. Hence, the cabling 44 is situated in a cold aisle 76, 78, as on the back side of a cabinet generally hot or warm air is emitted. Another possibility is to position the panels 81, 82, 83, 84 in the middle region of the cabinets' top and to place the cabling above the cabinets next to the side of the panels 81, 82, 83, 84 which faces the cold aisles 76, 78.

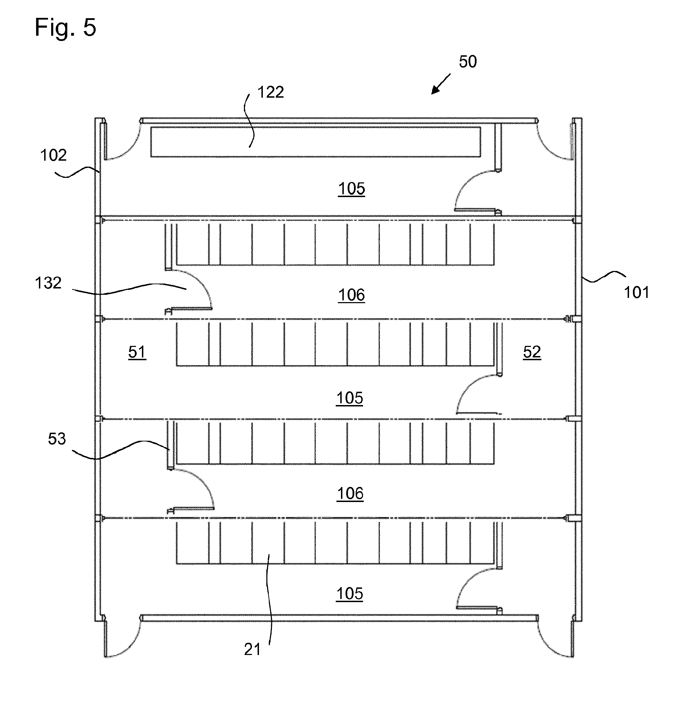

In fig. 5, a layout of a further embodiment of a modular data center 50 according to the invention is shown.

This data center 50 is built comprising four IT modules 101 and one end module 102, wherein the IT modules 101 and the end module 102 are connected in the way as already described forming cold aisles 105 and hot aisles 106. In opposite to the embodiment shown in fig. 1, here the cold aisle 105 and the hot aisles 106 are interconnected. The interconnection is achieved by two corridors, which are formed near the front and the back sides of the modules 101, 102 of the data center 50. The cold aisles 105 and hot aisles 106 are closed on one end, as shown in fig. 5 by means of doors 132 and walls 53. Based on this layout, a cold area is formed by the cold aisles 105 and an in-module corridor 51, which is fluid technically connected to the cold aisles 105 and a hot area is formed in a similar manner by the hot aisles 106 and a further in-module corridor 52.

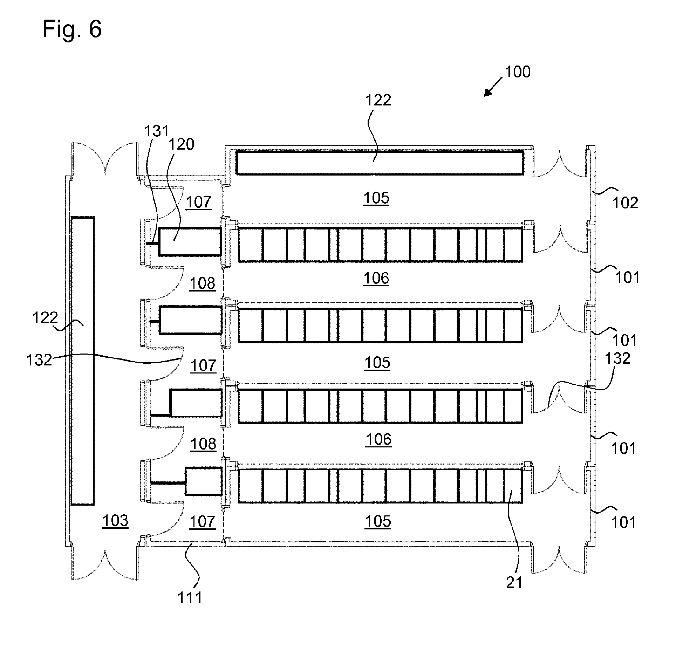

In fig. 6, a layout of another embodiment of a modular data center 100 according to the invention is shown.

This data center 100 is built comprising four IT modules 101, one end module 102, one cooling module 111 and one corridor module 103.

The IT modules 101 and the end module 102 are connected in the way as already described forming cold aisles 105 and hot aisles 106. On the front side of the IT modules 101 and the end module 102, a cooling module 111 is provided which is placed with one of its lateral sides facing the front sides of the afore-mentioned modules.

The cooling module 111 is provided with cooling means 120 which are positioned parallel to the front and back side of the cooling module 111. With the cooling means 120 and walls or separations 131 compartments are formed. These compartments are fluid technically connected to the aisles of the IT and end modules 101, 102. Thus, cold compartments 107 and hot compartments 108 are formed.

The cooling means 120 draw or suck hot air out of the hot compartments 108 and blow it to the cold compartments 107. As the cold compartments 107 are fluid technically connected to the cold aisles 105 and the hot compartments 108 are fluid technically connected to the hot aisles 106, air of the hot aisles 106 is removed by the cooling means 120 and cooled air is blown in the cold aisles 105 via the cold compartments 107.

It is preferred that the cooling means have approximately the height of a ceiling height of a module and draw the hot air from the front side and blow it to the back side, or vice versa. If cooling means are used which draw the hot air from the top of the cooling means, there must be provided enough space above the cooling means to ensure a sufficient air volume flow.

In this embodiment a corridor module 103 is additionally provided next to the cooling module 111. As in the case of end module 102 also in the corridor module 103 technical working space 122 is provided. Further on, in the modules doors 132 are provided to access the different corridors, aisles and compartments.

It is preferred that the connections between adjacent modules are provided with standard connecting means so that it is easily possible to connect for example fluid pipes or power cables.

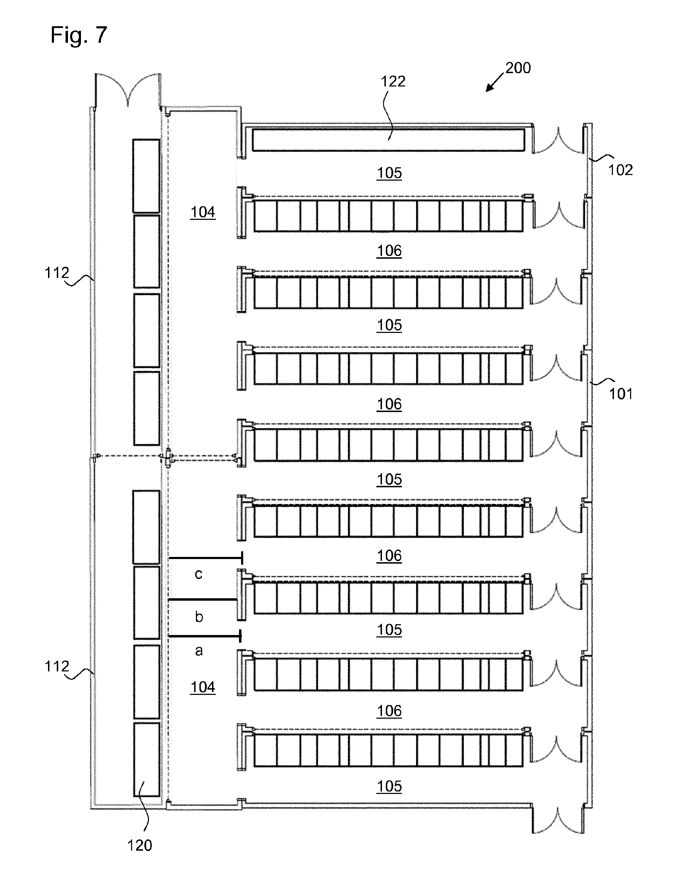

Fig. 7 shows a layout of a further embodiment of a modular data center 200 according to the invention. This data center 200 comprises eight IT modules 101, one end module 102, two redundancy modules 104 and two cooling modules of a second type 112.

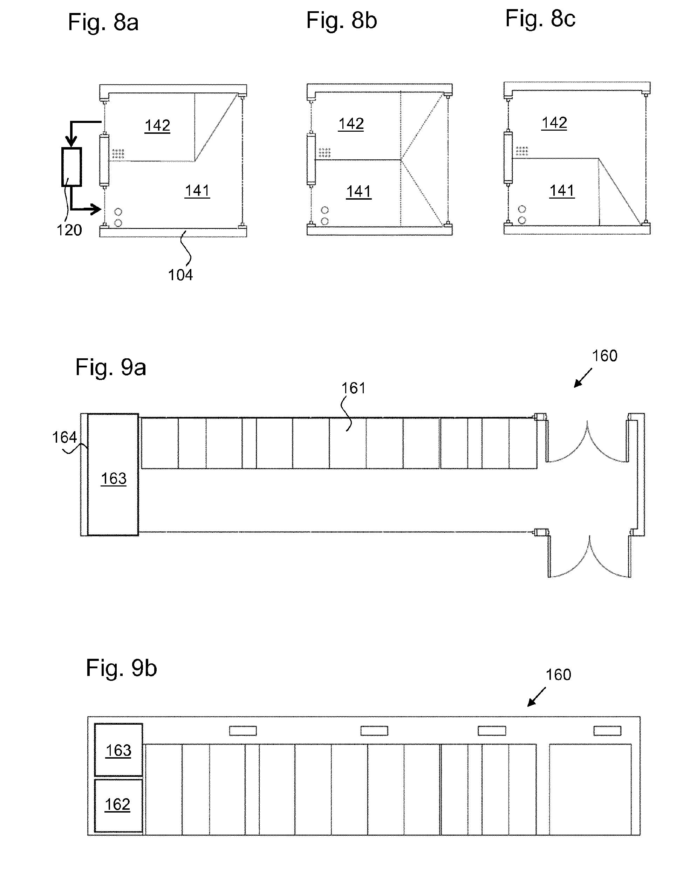

The IT modules 101 and the end module 102 are arranged in the same way as explained with respect to the other embodiments of the modular data center forming a plurality of cold aisles 105 and hot aisles 106. All cold aisles 105 and all hot aisles 106 are interconnected by means of the redundancy module 104. The exact construction of a redundancy module 104 will now be described in greater detail with reference to figs. 8a to 8c.

Figs. 8a to 8c show sectional views of use of a redundancy module 104, wherein fig. 8a shows a sectional view along line a of fig. 7, fig. 8b along line b and fig. 8c along line c.

As shown in fig. 8b, the redundancy module 104 comprises two ducts 141 and 142. In this embodiment and in view of the following explanation, it is assumed that the duct 141 is used for cold air and therefore referred to as cold duct 141 and the duct 142 is used for heated air and therefore in the following is referred to as hot duct 142.

In this sectional view an opening is provided on the left side of each duct. Via this opening cooling means 120 draw the hot air from the hot duct 142 and blow the cooled air into the cold duct 141. To provide a connection to the hot aisles 106 and cold aisles 105, respectively, a special construction is provided in addition to the ducts 141 and 142, as can be seen in fig. 8a and 8c. In detail, in the regions where the lateral side of the redundancy module 104 faces the front or the back side of an IT module or end module having a cold aisle 105, a fluid technical connection is provided between the cold duct 141 and the cold aisle 105. This connection can be achieved in many different ways. In figs. 8a and 8c, this connection is realized by a conical part which extends the respective duct. The same construction is also provided in view of the hot duct 142 to connect the hot duct 142 to a plurality of hot aisles 106.

Based on this construction of the redundancy module 104, all cold aisles 105 inside the IT modules and end modules and all hot aisles 106 inside the other IT modules can be interconnected, respectively. This interconnection provides the above already mentioned advantages of an air exchange between the plurality of cold aisles 105 and hot aisles 106, respectively.

Figs. 9a and 9b show a further embodiment of an IT module 160 with an integrated redundancy feature. This IT module 160 is shown in layout in fig. 9a and in a sectional view along the middle line of the central longitudinal axis of the IT module 160 in fig. 9b.

On the front side 164 of the IT module 160, two ducts 162 and 163 are provided. These ducts extend as can be seen in fig. 9a in view of the duct 163, from one lateral side of the module to the other one. They are used in the same way as the hot and cold ducts of the redundancy modules. Thus, if a plurality of IT modules 160 is placed side by side to each other forming several hot and cold aisles, it is possible to fluid technically connect the hot aisles and the cold aisles of the plurality of IT modules 160, respectively, by means of the in-module ducts 162 and 163. The duct 162 can for example be used as a cold duct so that the interior of this duct is fluid technically connected to the interiors of all IT modules 160 forming a cold aisle, wherein the duct 163 which is used as a hot duct, is fluid technically connected to the interiors of all IT modules forming hot aisles.

This leads to the same result as the redundancy module so that all cold aisles and all hot aisles are interconnected, respectively. The advantage of this solution compared to a specialized redundancy module is that no further module is required to provide the redundancy. On the other hand, there is less space for cabinets in the rows 161 in the IT module 160 and the connections between the aisle and the ducts of the inmodule ducts are smaller than the connections between aisles and the redundancy module ducts. Therefore, less air can be exchanged leading to reduced redundancy efficiency.

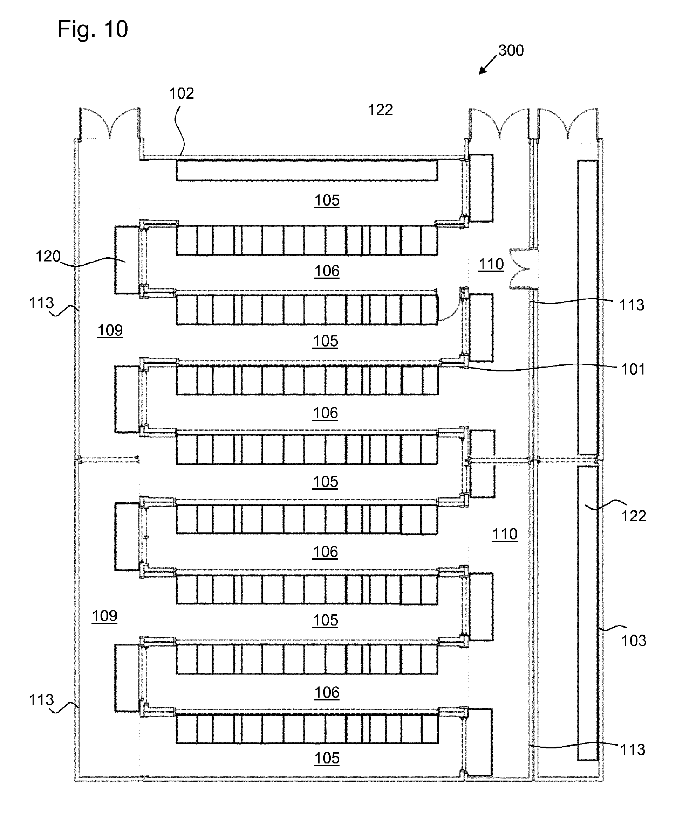

Fig.10 shows the layout of a further embodiment of a modular data center 300 according to the invention. This data center 300 comprises eight IT modules 101, one end module 102, four cooling modules 113 of a third type and two walk-in corridor modules 103.

The IT modules 101 and end module 102 are again arranged in a way to form a plurality of cold aisles 105 and hot aisles 106. According to this embodiment, a type of cooling module 113 is used wherein the cooling means 120 are arranged parallel to the lateral sides of the cooling module 113. Further on, between the cooling means 120 in the cooling module 113, free space is provided. Thus, it is possible to fluid technically interconnect all cold aisles 105 via the cooling modules 113 on the left side, the lateral sides of which face the front side of the IT modules 101 and the end module 102. Thereby, the interior space of the cooling modules 113 forms an extended cold aisle 109. In this way the cooling module 113 of the third type can also be used as a walk-in corridor. Therefore, this cooling module type could also be called combined cooling corridor module.

A similar construction is used for the two cooling modules 113 provided on the back side of the IT modules 101 and the end module 102. In this case, the space inside the cooling modules 113 forms an extended hot aisle 110 of the IT modules 101. This again leads to a redundancy in view of the thermal management.

As can be seen in fig. 10, the cooling means 120 of the two cooling modules 113 on the left side draw the hot air directly from the hot aisles 106 and blow it as cooled air into the extended cold aisle 109. In opposite thereto, the cooling means 120 on the right side draw the hot air which should be cooled from the extended hot aisle 110 and blow it directly into the cold aisles 105.

Additionally, next to the two cooling modules 113 on the right side two corridor modules 103 are provided which are mainly used for providing access to the IT modules 101 and the end module 102. Even though only one door in the corridor of the corridor modules 103 is shown, more doors could be provided to ease access to the IT modules 101 and the end module 102. Inside the end module 102 and the corridor modules 103, a technical working space 122 is again provided. It is advantageous for the construction of the data center if the additional technical workings spaces 122 are preferably arranged in a cold aisle 105 or an area provided with cold air. It is also possible to provide the technical area 122 inside an area which is not used for the thermal management of the data center. It is also possible to provide the technical area inside an area with hot air which is however not preferred as it may be inconvenient to work in this area due to an air temperature of about 27°C or even more.

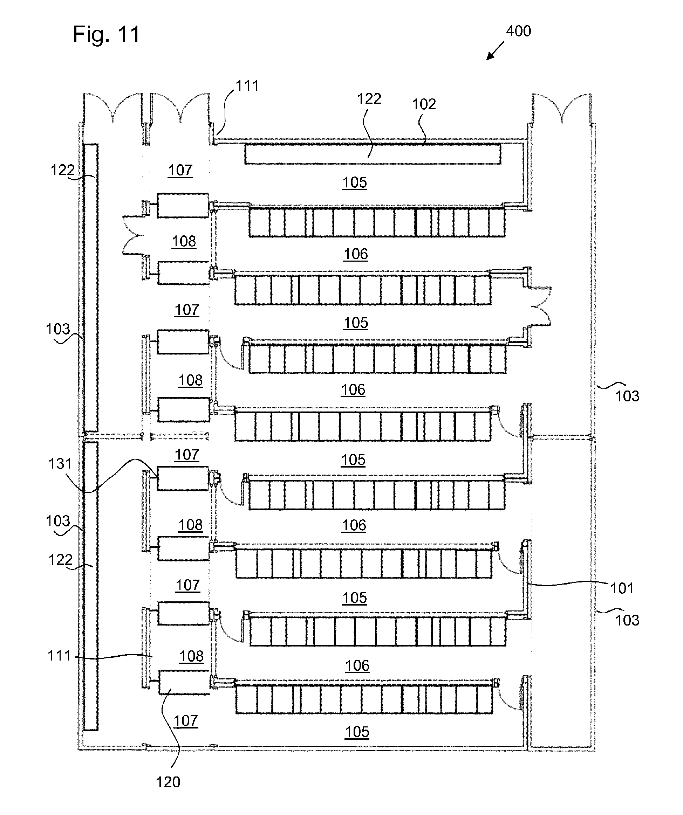

The layout of the data center 300 of fig. 10 forms a finger- or comb-like structure of cold and hot areas in the data center 300. The cold and hot areas intertwine. The comb-like structure of the cold area is set up by the two cooling modules 113 on the left side forming the shaft of the comb and the cold aisles 105 forming the teeth of the comb. The hot area is set up in the same way by the two cooling modules 113 on the right side forming the shaft and the hot aisles 106 forming the teeth. The interconnection of the cold and hot aisles is realized by connections, which are at the same ground level as no suspended ceiling and/or raised floor are used. This concept is continued also in the embodiments of figs. 11 to 14, as will be described below. It is realized even by the redundancy construction of the embodiments of figs. 7 to 9.

Fig. 11 shows a further layout of another embodiment of a modular data center 400 according to the invention. In this case, the data center 400 again comprises eight IT modules 101, one end module 102, four corridor modules 103 and two cooling modules 111 of a second type.

Generally, when using standard ISO-containers it is advantageous to always use nine containers placed side by side and then to place two containers lengthwise to these other nine containers. As can be seen exemplarily from this layout, this leads to a nearly rectangular base of the data center. If specially designed containers are used - e.g. for cooling modules - they should preferably have a length which is an integer multiple of the width of the IT module or the end module. The length of a cooling module may be especially four or five times the width of an IT module.

In this embodiment, next to the front of the IT modules 101 and the end module 102, two cooling modules 111 of the second type are placed in which cold and hot compartments 107 and 108 are formed. Here, the free space inside the corridor modules 103 on the left side is fluid technically connected via the cold compartments 107 to the cold aisles 105 thereby providing a redundancy. As a result of this construction a cold corridor inside the corridor module 103 is formed. The cooling means 120 in this case are arranged in a way to draw hot air out of the hot compartments 108 and to provide the cooled air to the cold compartments 107. From these cold compartments 107 air can flow into the different cold aisles 105 also via the interior of the corridor modules 103 on the left side.

To provide a further redundancy in view of the hot aisles 106 they are interconnected via the interior of the corridor modules 103 on the right side forming a hot corridor. In the cold areas of the data center, a technical area 122 is again provided. Based on the inventive construction, fingerlike structures of cold areas and hot areas are provided wherein the fingers of the cold areas intertwine with the fingers of the hot areas.

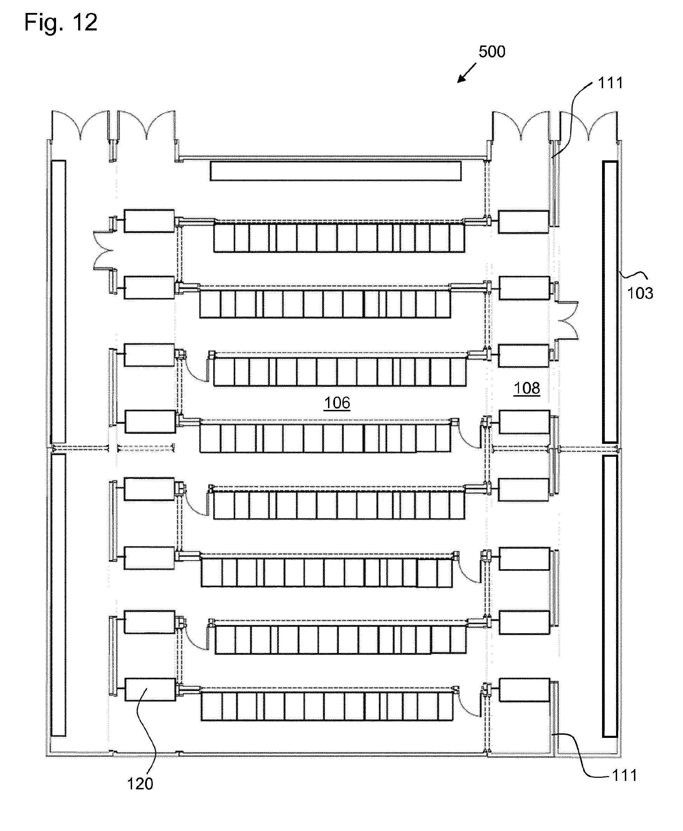

If a higher degree of cooling is needed, for example because the computing devices inside the cabinets produce more heated air or the heated air has a higher temperature, the data center 400 of fig. 11 can be upgraded to the data center 500 shown in fig. 12.

The main difference between these two data centers 400, 500 is that according to the embodiment of fig. 12, two additional cooling modules of the second type 111 are provided. These modules 111 are placed and used in the same way as the cooling modules 111 in view of the embodiment of fig. 11. In detail, they are placed between the IT modules 101 and the end module 102 and the two corridor modules 103 on the right side. Thereby, the connection of the hot aisles 106 to the interior of the corridor modules 103 on the right side is realized via the hot compartments 108 of these two additional cooling modules 111.

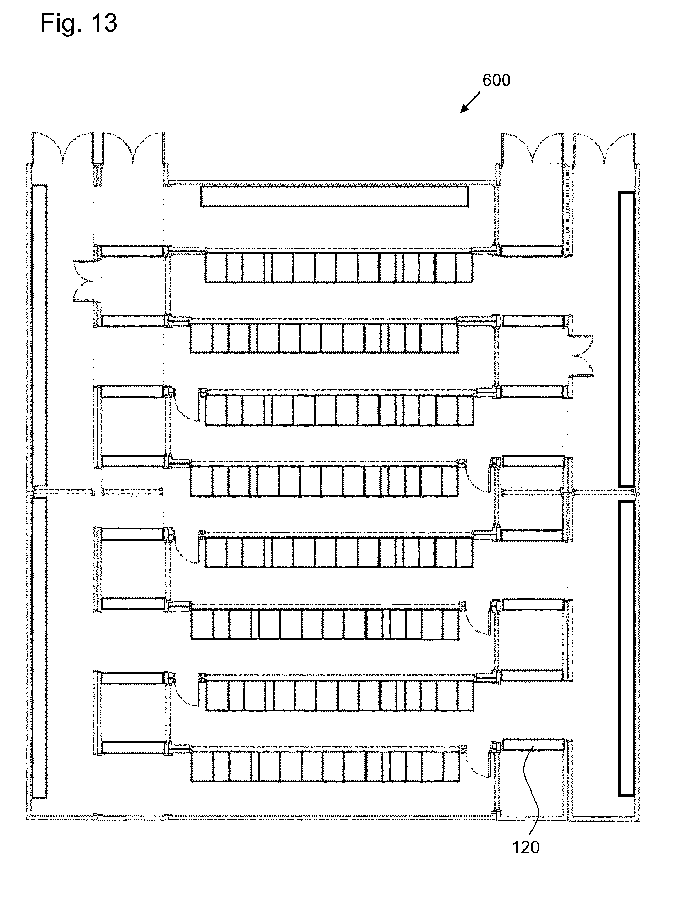

In fig. 13, a further modular data center 600 which is based on the modular center 500 shown in fig. 12 is illustrated. In the data center 500 of fig. 12, the cooling means 120 are of the circulating devices type. In contrast thereto, according to the embodiment shown in fig. 13, in this data center 600 so called cooling walls are used which are for example known from EP 2 317 236 A1 to cool the hot air of the hot aisles and to provide cooled air to the cold aisles.

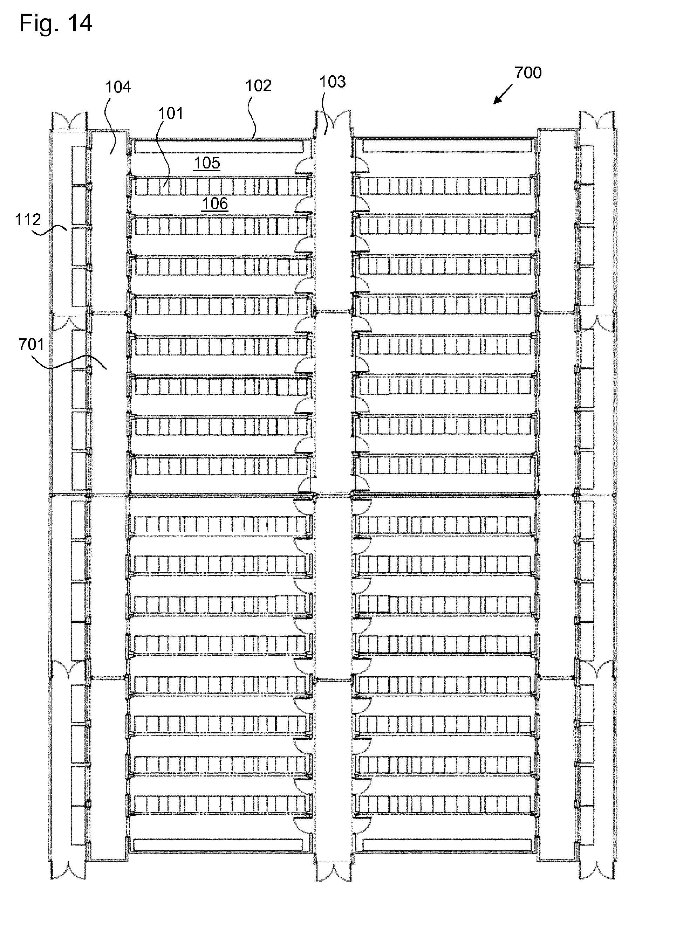

Fig. 14 shows the layout of a further alternative embodiment of a modular data center 700 according to the invention. This data center 700 is constructed based on four data center parts 701 which are built up in a similar manner. Part 701 is set up related to the style of to the data center 200 explained with respect to fig. 7. Each part of the data center 700 is set up of eight IT modules 101, one end module 102, two redundancy modules 104 and two cooling modules of the second type 112.

Between the parts 701 of the data center 700, four corridor modules 103 are provided to provide access to the hot and cold aisles 105 and 106.

As is shown by this embodiment of the modular data center 700, the different embodiments explained in this application and any other embodiment using the inventive teaching can be simply upscaled by copying, mirroring and/or turning using data center parts. Further on, if a further upscaling is needed, and the modules are provided in containers, it is also possible to pile up containers up on each other so that the layout of one data center is used to construct a data center with multiple floors by placing containers on top of each other. In addition to the placement of the IT modules and the end module side by side, it is further possible to place two or more modules in a way that the front side of one module faces the back side of the next module.

In summary, one further inventive concept is the building of finger- or comb-like structures of hot and cold areas in a data center. In detail hot and cold aisle, respectively, are interconnected to provide a redundancy of the thermal system. This interconnection can e.g. be realized by corridor modules and in-row coolers only, by specifically designed cooling modules such as the ones in fig. 10, by a combination of cooling and corridor modules such as the ones in figs. 11, 12 and 13, by redundancy and cooling modules such as the ones in fig. 7 and 13, or by a combination of the mentioned possibilities.

Based on the modular data center according to the invention, it is possible to provide and improve a thermal management, also if the ceiling height is quite low.

## Claims

1. Modular data center
having at least two different types of modules, an IT module (10, 20, 60, 101) and an end module (30, 102),
wherein each module (10, 20, 30, 60, 101, 102) has a cuboidlike form and comprises
- a top and a bottom side,
- a front (16) and a back side (17),
- a first (18) and a second lateral side (19) having the same length as the top and the bottom side, respectively
wherein the top side forms an interior ceiling and
wherein in the IT module (10, 20, 60, 101) a row (11, 21) of cabinets (12, 22 62) is provided,
wherein one side of the row (11, 21) is positioned at or close to the first lateral side (18) of the IT module (10, 20, 60, 101) and sealing means (48) extend from the ceiling to the top of each cabinet in the row (11, 21) of cabinets (12, 22 62),
wherein the first lateral side (18) is closed at least partially by the sealing means (48) in a manner that air flowing from the interior of the IT module (10, 20, 60, 101) to the outside of the IT module (10, 20, 60, 101) through the first lateral side (18), or vice versa, passes through the cabinets (12, 22, 62) of the row (11, 21),
wherein the end module (30, 102) and the IT module (10, 20, 60, 101) are coupled side by side so that the second lateral side (19) of the end module (30, 102) faces the first lateral side (18) of the IT module (10, 20, 60, 101) and that an airflow from the interior of the IT module (10, 20, 60, 101) to the interior of the end module (30, 102), or vice versa, through the cabinets (12, 22, 62) in the row (11, 21) is enabled,
wherein during operation the interior of one module (10, 20, 30, 60, 101, 102) forms a hot aisle (23, 106) and the interior of the other module (10, 20, 30, 60, 101, 102) forms a cold aisle (13, 33, 105), and
wherein cooling means (41, 120) are provided for cooling heated air of the hot aisle (23, 106) and for transferring the cooled air to the cold aisle (13, 33, 105).

2. Modular data center according to claim 1,
**characterized by**
two or more IT modules (10, 20, 60, 101) which are coupled side by side so that the first lateral side (18) of one IT module (10, 20, 60, 101) faces the second lateral side (19) of another IT module (10, 20, 60, 101) and
that an airflow from the interior of one IT module (10, 20, 60, 101) to the interior of the other IT module (10, 20, 60, 101), or vice versa, through the cabinets (12, 22, 62) in the rows (11, 21) is enabled and hot aisles (23, 106) and cold aisles (13, 33, 105) are formed in an alternating manner.

3. Modular data center according to claim 1 or 2,
**characterized in that**
cold aisles (13, 33, 105) and/or hot aisles (23, 106) are interconnected fluid technically, respectively, via connections being on the same ground level as the cold aisles (13, 33, 105) and/or hot aisles (13, 33, 105) forming cold and/or hot areas.

4. Modular data center according to claim 3
**characterized in that**
the cold and/or hot areas have a comb-like layout,
wherein a shaft of the comb-like layout is formed by the connection, respectively, and teeth of the comb-like layout are formed by the cold (13, 33, 105) and/or hot aisles (13, 33, 105), respectively.

5. Modular data center according to claim 3 or 4
**characterized in**
**that** cold aisles (13, 33, 105) and hot aisles (13, 33, 105) are formed in one spatial direction in the alternating manner and
**that** the one or more connections extend in this spatial direction.

6. Modular data center according to one of the claims 3 to 5
**characterized in that**
the one or more connections are formed as one or more walk-in corridors.

7. Modular data center according to one of the claims 3 to 6,
**characterized in that**
the connection is formed by a corridor module (103)
- forming a cold or hot corridor, respectively, being directly or indirectly fluid technically connected to hot (106) or cold aisles (105) of the IT modules (101) and the end module (102), respectively.

8. Modular data center according to claim 7,
**characterized by**
cooling means being placed inside the corridor module (103) along one of the lateral sides of the corridor module (103) forming a combined cooling corridor module (113).

9. Modular data center according to one of the claims 1 to 8,
**characterized by**
at least one cooling module (111) of a first type
- being coupled to the IT module(s) (101) and the end module (102) so that one lateral side (18, 19) of the cooling module faces the front sides (16) or back sides (17) of the IT module(s) (101) and the end module (102),
- having separations (131) extending the hot and cold aisle(s) (105, 106), which form hot (108) and cold compartments (107),
- having cooling means (120) for cooling heated air of the hot aisle(s) (106) and for transferring the cooled air to the cold aisle(s) (105) via cold compartments (107), and
wherein the cooling means (120) form a part of the separations (131).

10. Modular data center according to claim 9,
**characterized by**
a corridor module being coupled side by side to a first cooling module (111) of the first type so that the lateral side of the first cooling module (111), which is opposite to the lateral side of the first cooling module (111) facing the IT module(s) (101) and the end module (102), faces a lateral side of the corridor module (103).

11. Modular data center according to one of the claims 2 to 10,
**characterized by**
a redundancy module (104)
- being coupled to the IT modules (101) and the end module (102) so that the lateral side of the redundancy module (104) faces the front sides or back sides of the IT module(s) (101) and the end module (102),
- having a horizontal segmentation forming a hot air duct (142) and a cold air duct (141),
- having openings and air guides for fluid technically connecting the hot aisles (106) to the hot air duct (142) and the cold aisles (105) to the cold air duct (141), and
wherein the hot air duct (142) is an upper air duct and the cold air duct (141) is a lower air duct or vice versa.

12. Modular data center according to one of the claims 1 to 11,
**characterized in**
**that** each IT module (160) has two ducts (162, 163)
- being disposed on each other,
- extending from the first lateral side to the second lateral side of the IT module (160) so that hot aisles (106) and cold aisles (105) of plural IT modules (160) and the end module (102) are fluid technically connected, respectively.

13. Modular data center according to one of the claims 1 to 12,
**characterized in that**
the row of cabinets (11, 21) comprises at least one cooling means (41) for cooling heated air of the hot aisle (23, 106) and for transferring the cooled air to the cold aisle (13, 33, 105).

14. Modular data center according to one of the claims 1 to 13,
**characterized by**
panels (48) and/or doors (132) being provided in modules (101, 102, 103, 111, 112, 113) for partly sealing a module (101, 102, 103, 111, 112, 113) in an air tight manner.

15. Modular data center according to one of the claims 1 to 14,
**characterized in that**
the exterior of each module (101, 102, 103, 104, 111, 112, 113) is at least partly formed by a standard ISO-container wherein the lateral, front and back panels may be at least partly removed.
